(19)

Europäisches
Patentamt
European
Patent Office
Office européen
des brevets

(11) **EP 1 804 279 A1**

(12) **EUROPEAN PATENT APPLICATION**
published in accordance with Art. 158(3) EPC

(43) Date of publication:
**04.07.2007 Bulletin 2007/27**

(21) Application number: **05783360.0**

(22) Date of filing: **16.09.2005**

(51) Int Cl.:
*H01L 21/027* (2006.01)    *G03F 7/20* (2006.01)
*H01L 21/02* (2006.01)

(86) International application number:
**PCT/JP2005/017180**

(87) International publication number:
**WO 2006/030910 (23.03.2006 Gazette 2006/12)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **17.09.2004 JP 2004271636**

(71) Applicant: **NIKON CORPORATION**
**Tokyo 100-8331 (JP)**

(72) Inventor: **MIZUTANI, Takeyuki,**
**c/o NIKON CORPORATION,**
**Tokyo 1008331 (JP)**

(74) Representative: **HOFFMANN EITLE**
**Patent- und Rechtsanwälte**
**Arabellastraße 4**
**81925 München (DE)**

(54) **SUBSTRATE FOR EXPOSURE, EXPOSURE METHOD AND DEVICE MANUFACTURING METHOD**

(57)    A substrate for exposure prevents interference with a substrate holder at the time of being loaded onto the substrate holder and prevents a liquid from entering into a rear plane side after being loaded. A substrate (P) for exposure is a substrate to be exposed by irradiation of exposure light through the liquid, and has a size tolerance (DP) of an outer diameter (LP) of $\pm 0.02$ mm or less.

## FIG. 1A

**Description**

TECHNICAL FIELD

The present invention relates to a substrate for exposure to be exposed by exposure light being radiated through a liquid, an exposure method that exposes that substrate for exposure, and a device manufacturing method.

The present application claims priority to Patent Application No. 2004-271636 filed on September 17, 2004, and the contents thereof are incorporated herein by reference.

BACKGROUND ART

In a photolithography process, which is one of the manufacturing processes for microdevices such as semiconductor devices and liquid crystal display devices, an exposure apparatus that projection-exposes a pattern formed on a mask onto a photosensitive substrate is used. This exposure apparatus has a mask stage apparatus that supports the mask and a substrate stage apparatus that supports the substrate, and it projection-exposes the pattern of the mask onto the substrate via a projection optical system while sequentially moving the mask stage apparatus and the substrate stage apparatus. In the manufacture of microdevices, due to higher densities of the devices, miniaturization of the pattern formed on the substrate is in demand. In order to respond to this need, higher resolutions for exposure apparatuses have been in demand, and liquid immersion exposure apparatuses that perform exposure processing in a status in which the space between the projection optical system and the substrate has been filled with a liquid that has a higher refractive index than a gas, such as that disclosed in Patent Document 1 below, have been proposed as one of the means for realizing those higher resolutions.

Patent Document 1: PCT International Publication No. WO 99/49504.

DISCLOSURE OF INVENTION

PROBLEMS TO BE SOLVED BY THE INVENTION

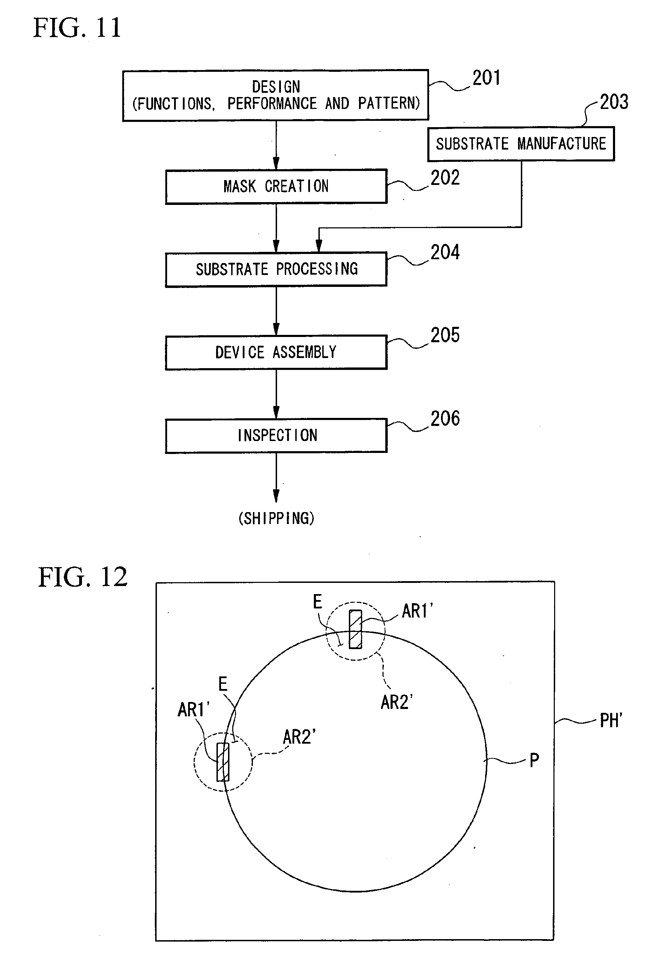

As shown in FIG 12, in the case where an edge area E on a substrate (substrate for exposure) held by a substrate holder PH' of a substrate stage apparatus is liquid-immersion-exposed, a case in which a portion of a liquid immersion area AR2', which covers the projection area AR1' of the projection optical system is formed outside the substrate P occurs. In such cases as when the edge area E of the substrate P is exposed in a status in which a portion of liquid immersion area AR2' has been formed outside the substrate P, if the dimensional error (manufacturing error) of the outer diameter of the substrate P is large, and the gap (interval) between the substrate P and the substrate holder PH' is large, there is a possibility that the liquid will penetrate into that gap. In that case, there is a possibility that the substrate holder PH' will not be able to hold the substrate P well. There is a possibility that deterioration of the flatness of the held substrate P will be caused due to, for example, the liquid penetrating between the rear surface of the substrate P and the substrate holder PH'. Or, it is also conceivable that adherence marks (hereunder, even in cases in which the liquid is not pure water, those adherence marks are referred to as water marks) will be formed due to the vaporization of the penetrated liquid. Because those water marks act as foreign matters, there is a possibility that deterioration of the flatness of the substrate P held by the substrate holder PH' will be caused. In addition, there is also a possibility that a nonconformity will occur, for example, such that the substrate P, the substrate holder PH', etc. thermally deforming due to the heat of vaporization when the liquid that has penetrated between the substrate P and the substrate holder PH' has vaporized. In addition, when the dimensional error of the outer diameter of the substrate P is large, and the substrate P is loaded onto the substrate holder PH', there is a possibility that the substrate P and the substrate holder PH' will interfere with each other, and the substrate P or the substrate holder PH' will be damaged.

The present invention was made taking such circumstances into account, and its purpose is to provide a substrate for exposure that is suitable for liquid immersion exposure, an exposure method that exposes that substrate for exposure, and a device manufacturing method that uses that exposure method.

MEANS FOR SOLVING THE PROBLEM

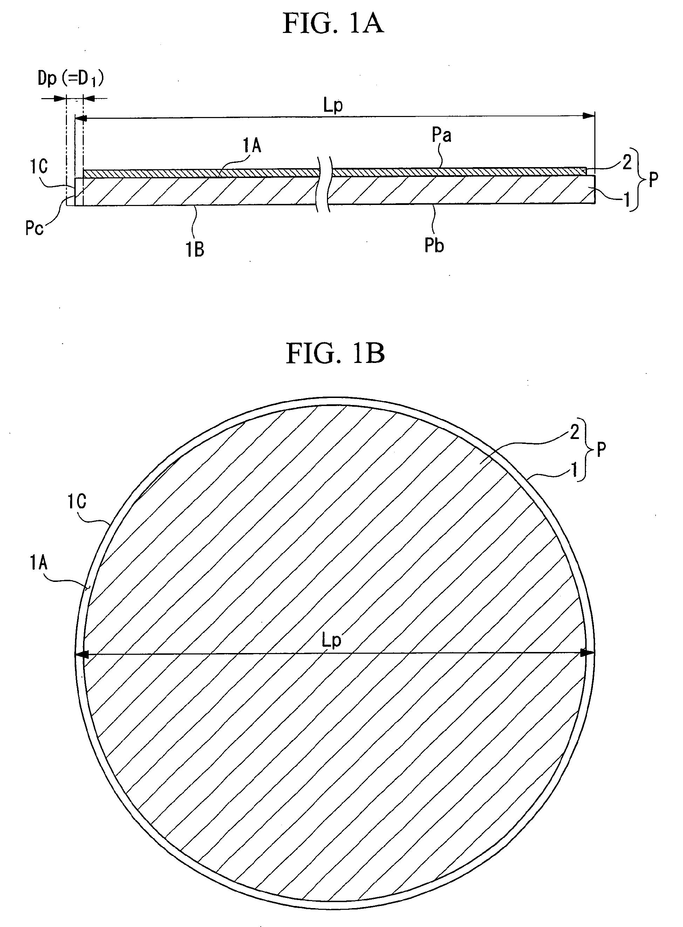

In order to solve the aforementioned problems, the present invention adopts the following configuration corresponding to FIG. 1A to FIG. 11 shown in the embodiments. However, codes in parentheses that have been assigned to the respective elements are nothing more than examples of those elements, and they do not limit the respective elements.

According to a first aspect of the present invention, there is provided a substrate for exposure that is to be exposed by exposure light (EL) being radiated through a liquid (LQ), wherein the dimensional tolerance ($D_P$) of the outer diameter ($L_P$) is $\pm 0.02$ mm or less.

According to the first aspect of the present invention, it is possible to maintain the gap of the periphery of the substrate for exposure held on the holder to a prescribed value or less by setting the dimensional tolerance of the outer diameter of the substrate for exposure to $\pm 0.02$ mm or less.

According to a second aspect of the present invention, there is provided an exposure method that radiates the exposure light (EL) to expose the substrate for exposure (P), in a status in which the substrate for exposure (P) of the above aspect is held by a holder (PH).

According to the second aspect of the present invention, it is possible to perform exposure processing with good accuracy in a status in which the substrate for exposure is held well by the holder, and penetration of the liquid to the rear surface side of the substrate for exposure is prevented.

According to a third aspect of the present invention, there is provided a device manufacturing method that uses an exposure method of the above aspect

According to the third aspect of the present invention, it is possible to provide a device that has the desired performance.

EFFECTS OF THE INVENTION

Through the present invention it is possible to expose the substrate for exposure with good accuracy even in the case in which the liquid immersion method is used. Therefore, it is possible to manufacture a device that has the desired performance.

BRIEF DESCRIPTION OF THE DRAWINGS

FIG. 1A is a vertical cross sectional view that shows an embodiment of a substrate for exposure.
FIG. 1 B is a horizontal cross sectional view that shows an embodiment of a substrate for exposure.
FIG. 2 is a cross sectional view that shows another embodiment of a substrate for exposure.
FIG. 3 is a cross sectional view that shows another embodiment of a substrate for exposure.
FIG. 4 is a cross sectional view that shows another embodiment of a substrate for exposure.
FIG. 5 is a schematic block diagram that shows an embodiment of an exposure apparatus.
FIG 6 is a side cross sectional view that shows a substrate holder that holds a substrate.
FIG. 7 is a plan view that shows a substrate holder that holds a substrate.
FIG. 8 is a cross sectional view that shows a plate member.
FIG. 9 is a drawing that shows a condition in which a plate member is removed from and attached to a substrate holder.
FIG. 10 is a drawing for explaining the operation of a loader apparatus.
FIG 11 is a flow chart that shows an example of a microdevice manufacturing process.
FIG 12 is a schematic drawing for explaining conventional problems.

DESCRIPTION OF THE REFERENCE SYMBOLS

1 : BASE MATERIAL, 1A : UPPER SURFACE, 1B : LOWER SURFACE, 1C : SIDE SURFACE, 2 : PHOTOSENSITIVE MATERIAL, 3 : FILM, 61 : BASE MATERIAL, 62 : FILM, 150 : LOADER APPARATUS, 100 : LIQUID IMMERSION MECHANISM, EL : EXPOSURE LIGHT, EX : EXPOSURE APPARATUS, LQ : LIQUID, P : SUBSTRATE FOR EXPOSURE, Pc : OUTER SIDE SURFACE, PH : SUBSTRATE HOLDER, PST : SUBSTRATE STAGE APPARATUS, T : PLATE MEMBER, Tc : INNER SIDE SURFACE.

BEST MODE FOR CARRYING OUT THE INVENTION

Embodiments of the present invention will be explained below while referring to the drawings, but the present invention is not limited to these.

Substrate

An embodiment of the substrate (substrate for exposure) will be explained while referring to FIG. 1A and FIG. 1B. FIG. 1A is a side cross sectional view that shows an embodiment of the substrate P, and FIG. 1A is a plan view of the substrate P. In FIG. 1A and FIG. 1B, the substrate P is a substrate for exposure that is to be exposed by exposure light being radiated via a liquid, and it has a base material 1 and a photosensitive material 2, which is coated onto the upper surface 1A of that base material 1. In the present embodiment, the base material 1 includes a silicon wafer. For example, the silicon wafers are formed by a process that forms a raw material ingot by the CZ (Czochralski pulling) method, which grows cylindrical crystals, a process that cuts the raw material ingot into single wafers, a process that polishes the surfaces, etc. of the respective wafers, a washing process for removing adhering substances, etc. of the surfaces of the respective wafers, and an inspection process in which a quality check of the respective wafers is performed. The photosensitive material 2 is coated only onto a partial area (nearly the entire area excluding the edge part) of the upper surface 1A of the base material 1, and it is not coated onto the side surface 1C and the lower surface 1B.

The substrate P has a circular shape in a planar view, and it is formed so that it has a prescribed diameter (outer diameter) $L_P$. The dimensional tolerance $D_P$ of the outer diameter $L_P$ of the substrate P (base material 1) is $\pm0.02$ mm or less. Note that it is even more preferable that the dimensional tolerance $D_P$ of the outer diameter $L_P$ of the substrate P (base material 1) be $\pm0.01$ mm or less. The diameter $L_P$ of the substrate P (base material 1) of the present embodiment is 300 mm, but it may also be 150 mm or 200 mm. In addition, the substrate P in the present embodiment is approximately circular shape, but a cut portion (notch portion, orientation flat portion) may be formed at a part of the edge thereof. In the substrate P shown in FIG. 1 A and FIG. 1B, a material film is not coated onto the outer side surface 1C of the base material 1, so the dimensional tolerance $D_P$ of the outer diameter $L_P$ of the substrate P refers to the dimensional tolerance $D_1$ of the outer diameter $L_1$ of the base material 1.

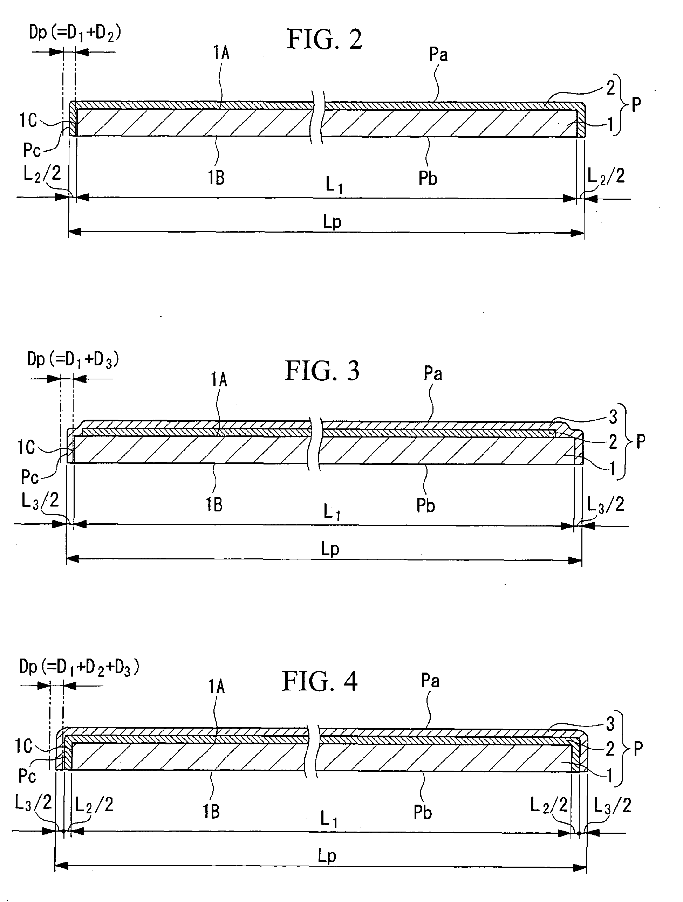

FIG. 2 is a side cross sectional view that shows another embodiment of the substrate P. In FIG 2, the substrate P has a base material 1 and a photosensitive material 2, which is coated onto the upper surface 1 A and the side surface 1C of the base material 1. In addition, as shown in FIG. 2, in the case in which the photosensitive material 2 is coated onto the side surface 1C of the base material 1, the outer diameter $L_P$ of the substrate P becomes the sum total of the outer diameter $L_1$ of the base material 1 and the film thickness $L_2$ of the photosensitive material 2 that has been coated onto the side surface 1C of that base material 1 (specifically, $L_P = L_1 + L_2$). Even in such a case, the dimensional tolerance $D_p$ of the outer diameter $L_P$ of the substrate P is set to $\pm0.02$ mm or less (or preferably 0.01 mm or less). In addition, the dimensional tolerance $D_P$ of the outer diameter $L_P$ of the substrate P in this case is the sum of the dimensional tolerance $D_1$ of the outer diameter $L_1$ of the base material 1 and the dimensional tolerance $D_2$ of the film thickness $L_2$ of the photosensitive material 2 that has been coated onto the side surface 1C of that base material 1 (specifically, $D_P = D_1 + D_2$).

Note that the substrate P of FIG. 1 A, FIG. 1B and FIG. 2 is to be exposed by the liquid immersion exposure method in a status in which a liquid immersion area is formed at least a portion on the substrate P. Therefore, the photosensitive material 2 that is coated onto the base material 1 is such that the contact angle with the liquid that forms that liquid immersion area is 60° or higher, and, more preferably, 80° or higher.

FIG. 3 is a side cross sectional view that shows another embodiment of the substrate P. In FIG. 3, the substrate P has a base material 1, a photosensitive material 2 that is coated onto a portion of the upper surface 1A of the base material 1, and a film 3 that is provided so as to cover the photosensitive material 2 and the side surface 1C of the base material 1. The film 3 is configured by a material different from the photosensitive material 2, and it is provided for such purposes as protection of the photosensitive material 2. In the explanation below, the film of the outermost layer, which covers the photosensitive material 2, of the substrate P is appropriately referred to as the "top coat film. " Therefore, as shown in FIG. 3, in the case in which a top coat film 3 has been coated onto the side surface 1C of the base material 1, the outer diameter $L_P$ of the substrate P becomes the sum total of the outer diameter $L_1$ of the base material 1 and the film thickness $L_3$ of the top coat film 3 that has been coated onto the side surface 1C of that base material 1 (specifically, $L_P = L_1 + L_3$). Even in such a case, the dimensional tolerance $D_P$ of the outer diameter $L_P$ of the substrate P is set to $\pm0.02$ mm or less (or, preferably, 0.01 mm or less). In addition, the dimensional tolerance $D_P$ of the outer diameter $L_P$ of the substrate P in this case is the sum of dimensional tolerance $D_1$ of the outer diameter $L_1$ of the base material 1 and the dimensional tolerance $D_3$ of the film thickness $L_3$ of the top coat film 3 that has been coated onto the side surface 1C of that base material 1 (specifically, $D_P = D_1 + D_3$).

FIG 4 is a side cross sectional view that shows another embodiment of the substrate P. In FIG. 4, the substrate P has a base material 1, a photosensitive material 2, which covers the upper surface 1A and the side surface 1C of the base material 1, and a top coat film 3, which covers that photosensitive material 2. Therefore, as shown in FIG. 4, in the case in which the photosensitive material 2 is coated onto the side surface 1C of the base material 1, and a top coat film 3, which covers that photosensitive material 2, is further provided, the outer diameter $L_P$ of the substrate P becomes the sum total of the outer diameter $L_1$ of the base material 1, the film thickness $L_2$ of the photosensitive material 2 that has been coated onto the side surface 1C of that base material 1, and the film thickness $L_3$ of the top coat film 3 that covers that photosensitive material 2 (specifically, $L_P = L_1 + L_2 + L_3$). Therefore, even in such a case, the dimensional tolerance $D_P$ of the outer diameter $L_P$ of the substrate P is set to $\pm0.02$ mm or less (or preferably 0.01 mm or less). In addition, the dimensional tolerance $D_P$ of the outer diameter $L_P$ of the substrate P in this case is the sum of dimensional tolerance $D_1$ of the outer diameter $L_1$ of the base material 1, the dimensional tolerance $D_2$ of the film thickness $L_2$ of the photosensitive material 2 that has been coated onto the side surface 1C of that base material 1, and the dimensional tolerance $D_3$ of the film thickness $L_3$ of the top coat film 3 (specifically, $D_P = D_1 + D_2 + D_3$).

Note that the substrate P of FIG 3 and FIG. 4 is also exposed by the liquid immersion exposure method in a status in which a liquid immersion area is formed at at least a portion on the substrate P. Therefore, the top coat film 3 that is coated onto the base material 1 is such that the contact angle with the liquid that forms that liquid immersion area is 90° or higher, and, more preferably, 100° or higher. In addition, it is also possible to use a fluorine group resin as the film material for the top coat film 3, but it is also possible to use a resin that has a strong base high polymer that has high affinity with the developing solution and that can be washed out together (removed) with the developing solution as the film material.

In addition, the photosensitive material 2 and the top coat film 3 discussed above can both be coated onto the base material 1 using a coater/developer apparatus that is commonly used in device manufacture, etc.

Exposure Apparatus

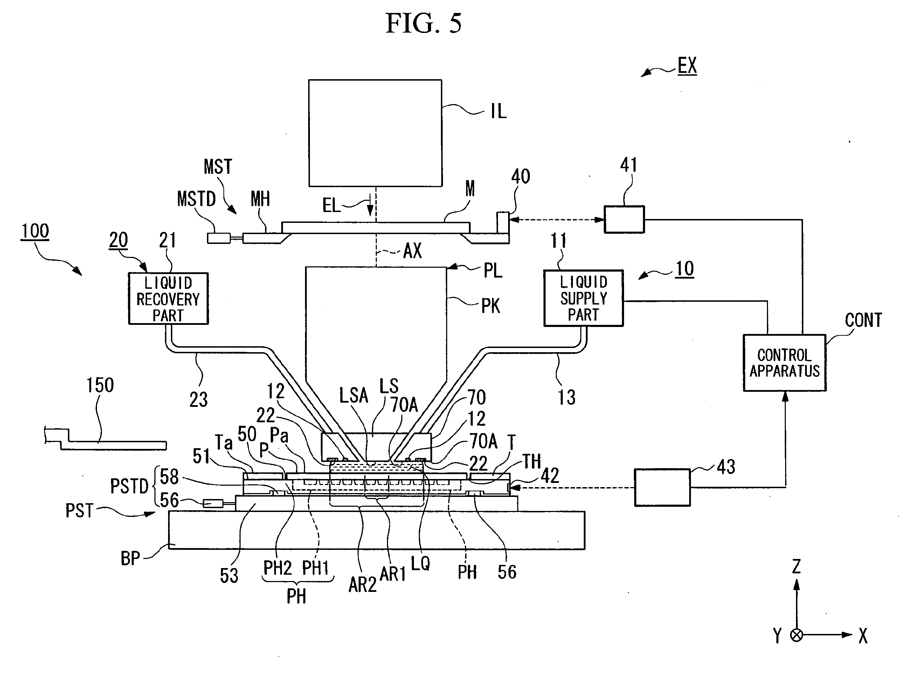

Next, the liquid immersion exposure apparatus EX discussed above that exposes the substrate P based on the liquid immersion method will be explained while referring to FIG. 5.

In FIG. 5, the exposure apparatus EX comprises a mask stage apparatus MST, which includes a mask holder MH, which holds the mask M, and a mask stage drive mechanism MSTD, which is able to move the mask holder MH, which holds the mask M, a substrate stage apparatus PST, which includes a substrate holder PH, which holds a substrate P, and a substrate stage drive mechanism PSTD, which is able to move the substrate holder PH, an illumination optical system IL that uses the exposure light EL to illuminate the mask M that is supported by the mask holder MH, a projection optical system PL, which projects the pattern image of the mask M illuminated by the exposure light EL onto the substrate P, which is supported by the substrate holder PH, and a control apparatus CONT, which comprehensively controls the operations of the entire exposure apparatus EX. In addition, the substrate holder PH has a plate member T to be discussed in detail below. The substrate holder PH comprises a first holder part PH1, which is for holding the substrate P and a second holder part PH2, which holds the plate member T, and the plate member T can be removed from and attached to the substrate holder PH (second holder part PH2).

In addition, the exposure apparatus EX comprises a loader apparatus 150, which loads the substrate P onto the substrate holder PH. In addition, though this is not shown in the drawing, the exposure apparatus EX comprises an unloader apparatus which is different from the loader apparatus 150, and which unloads the substrate P on the substrate holder PH. Note that the loader apparatus 150 may also have a function that unloads the substrate P on the substrate holder PH.

Here, in the present embodiment, an explanation will be given which uses as an example the case of a scanning type exposure apparatus (a so-called scanning stepper) that, as the exposure apparatus EX, synchronously moves the mask M and the substrate P in mutually different directions (opposite directions) in the scanning direction (prescribed direction) while exposing the substrate P using the pattern formed on the mask M. In the following explanation, the synchronous movement direction (scanning direction) of the mask M and the substrate P within the horizontal plane is the X axis direction, the direction perpendicular to the X axis direction within the horizontal plane is the Y axis direction (non-scanning direction), and the direction that is perpendicular to the X axis and Y axis directions and that matches the optical axis AX of the projection optical system PL is the Z axis direction. In addition, the rotation (tilting) directions about the X axis, the Y axis and the Z axis are the θX, θY and θZ directions respectively. Note that the "mask" referred to here includes reticles on which a device pattern to be reduction projected onto a substrate has been formed.

In addition, due to the configuration of the projection optical system PL, it is also possible to expose the substrate P while mutually synchronously moving the mask M and the substrate P in the same direction.

The illumination optical system IL uses exposure light EL to illuminate the mask M that is supported on the mask holder MH, and it has an exposure light source, an optical integrator that uniformalizes the illuminance of the luminous flux that has emerged from the exposure light source, a condenser lens that condenses the exposure light EL from the optical integrator, a relay lens system, and a field stop that sets the illumination area on the mask M resulting from the exposure light EL. The specified illumination area on the mask M is illuminated by exposure light EL with an even illuminance distribution by means of the illumination optical system IL. Used as the exposure light EL radiated from the illumination optical system IL are, for example, deep ultraviolet light (DUV light) such as ultraviolet band bright lines (g-rays, h-rays, i-rays) that emerge from a mercury lamp and KrF excimer laser light (wavelength of 248 nm) or vacuum ultraviolet light (VUV light) such as ArF excimer laser light (wavelength of 193 nm) and $F_2$ laser light (wavelength of 157 nm). In the present embodiment, ArF excimer laser light is used.

The mask stage apparatus MST includes a mask stage drive mechanism MSTD that is able to move the mask holder MH, which holds the mask M. The mask stage drive mechanism MSTD comprises a linear motor, etc., and the mask holder MH is two-dimensionally movable within a plane perpendicular to the optical axis AX of the projection optical system PL, that is, within the XY plane, and it is finely rotatable in the θZ direction due to the driving of the mask stage drive mechanism MSTD. Provided on the mask holder MH is a movable mirror 40 for a laser interferometer 41 for measuring the position of this mask holder MH. The position of the mask M on the mask holder MH in the two-dimensional direction and the angle of rotation are measured in real time by the laser interferometer 41, and the control apparatus CONT performs positioning of the mask M that is supported by the mask holder MH by driving the mask stage drive apparatus MSTD based on the measurement results of the laser interferometer 41.

The projection optical system PL projection-exposes the pattern of the mask M onto the substrate P at a prescribed projection magnification β, and it comprises a plurality of optical elements 2 that include optical elements (lenses) LS provided at the front end of the substrate P side, and these optical elements are supported by a lens barrel PK. In the present embodiment, the projection optical system PL is a reduction system in which the projection magnification β is 1/4, 1/5 or 1/8 for example. Note that the projection optical system PL may be either a magnification system or an enlargement system. In addition, the projection optical system PL may also be any of a reflecting system that does not include a refracting element, a refracting system that does not include a reflecting element, or a catadioptric system that includes both a refracting element and reflecting element. In addition, the optical elements LS of the front end part is exposed from the lens barrel PK.

The substrate stage apparatus PST includes a substrate stage drive mechanism PSTD, which is able to move the substrate holder PH, which holds the substrate P, on the image plane side of the projection optical system PL. The substrate stage apparatus PST comprises a movable member 53, which is movably supported on a base member BP, XY drive mechanisms 56, which move the movable member 53 in the X axis direction, the Y axis direction and the θZ direction on the base BP, and Z drive mechanisms 58, which are provided between the substrate holder PH and the movable member 53 and move the substrate holder PH in the Z axis direction, the θX direction and the θY direction on the movable member 53. The substrate stage drive mechanism PSTD includes the XY drive mechanisms 56 and the Z drive mechanisms 58, and the XY drive mechanisms 56 comprise, for example, a linear motor, etc., and the Z drive mechanisms 58 comprise, for example, a voice coil motor, etc. Three Z drive mechanisms 58 are provided (however, not shown in the drawing is the Z drive mechanism 58 at the rear side of the surface of the paper), and the substrate holder PH is supported at three points on the movable member 53 by the three Z drive mechanisms 58. The substrate stage drive mechanism PSTD is controlled by the control apparatus CONT. When the Z drive mechanisms 58 of the substrate stage drive mechanism PSTD are driven, the substrate holder PH is moved in the Z axis direction, the θX direction and the θY direction, and the substrate P held by that substrate holder PH is also moved in the Z axis direction, the θx direction and the θY direction in conjunction with this. In addition, when the XY drive mechanisms 56 are driven, the movable member 53 is moved in the X axis direction, the Y axis direction and the θZ direction, and, in conjunction with this, the substrate P held by the substrate holder PH is also moved in the X axis direction, the Y axis direction and the θZ direction via the Z drive mechanisms 58. Therefore, by driving the substrate stage drive mechanism PSTD, the substrate P held by the substrate holder PH is able to move in the directions with six degrees of freedom, which are the X axis, Y axis, Z axis, θX, θY and θZ directions. In addition, the plate member T also moves in the directions with six degrees of freedom together with the substrate P due to the driving of the substrate stage drive mechanism PSTD.

At the side surface of the substrate holder PH, a movable mirror 42 for a laser interferometer 43 for measuring the position of this substrate holder PH is provided. The position of the substrate P on the substrate holder PH in the two-dimensional direction and the angle of rotation are measured in real time by means of the laser interferometer 43, and the control apparatus CONT performs positioning of the substrate P, which is held by the substrate holder PH, in the X axis direction and the Y axis direction by driving the movable member 53 by means of the XY drive mechanisms 56 of the substrate stage drive mechanism PSTD within a two-dimensional coordinate system defined by the laser interferometer 43 based on the measurement results of the laser interferometer 43. In addition, the exposure apparatus EX comprises a focus detection system, which detects surface position information of the upper surface Pa of the substrate P by projecting detection light to the upper surface of the substrate P from a diagonal direction, such as that disclosed in, for example, Japanese Unexamined Patent Application Publication No. H8-37149. The focus detection system is able to obtain the position (focus position) of the upper surface Pa of the substrate P in the Z axis direction with respect to the image plane of the projection optical system PL and the attitude (tilt of the upper surface Pa) of the substrate P in the diagonal direction. The control apparatus CONT aligns the position (focus position) in the Z axis direction and the position in the θX and θY directions of the substrate P, which is held by the substrate holder PH, and the upper surface Pa of the substrate P to the image plane, which is formed through the projection optical system PL and the liquid LQ, by driving the substrate holder PH by means of the Z drive mechanisms 58 of the substrate stage drive mechanism PSTD.

The exposure apparatus EX of the present embodiment is a liquid immersion exposure apparatus that applies the liquid immersion method to effectively shorten the exposure wavelength to improve resolution while effectively widening the depth of focus, and it comprises a liquid immersion mechanism 100 that is able to form a liquid immersion area AR2 of the liquid LQ on the substrate P. The liquid immersion mechanism 100 comprises an annular nozzle member 70, which is provided above the substrate P (substrate holder PH) and is provided so as to surround the optical element LS of the front end of the projection optical system PL, a liquid supply mechanism 10, which supplies the liquid LQ onto the substrate P via a liquid supply port 12 provided on the nozzle member 70, and a liquid recovery mechanism 20, which recovers the liquid LQ on the substrate P via the recovery port 22 provided on the nozzle member 70. The liquid supply mechanism 10 is for supplying a specified liquid LQ to the image plane side of the projection optical system PL, and it comprises a liquid supply part 11, which is able to transport the liquid LQ, and a supply pipe 13, one end portion of which connects to the liquid supply part 11. The other end portion of the supply pipe 13 connects to the nozzle member 70. The liquid supply part 11 comprises a tank, which accommodates the liquid LQ, a pressurization pump, a filter unit, etc. In addition, the liquid recovery mechanism 20 is for recovering the liquid LQ of the image plane side of the projection optical system PL, and it comprises a liquid recovery part 21, which is able to recover the liquid LQ, and a recovery pipe 23, one end portion of which is connected to the liquid recovery part 21. The other end portion of the recovery pipe 23 is connected to the nozzle member 70. The liquid recovery part 21 comprises a vacuum system (suction apparatus) such as a vacuum pump for example, a gas-liquid separator, which separates the recovered liquid LQ and gas, and a tank, which accommodates the recovered liquid LQ, etc.

The nozzle member 70 is provided above the substrate P (substrate holder PH), and the lower surface 70A of the nozzle member 70 opposes the upper surface Pa of the substrate P. The liquid supply port 12 is provided at lower surface 70A of the nozzle member 70. In addition, an internal flow passage, which connects the supply pipe 13 and the liquid supply port 12, is provided at the interior of the nozzle member 70. In addition, a liquid recovery port 22 is also provided at the lower surface 70A of the nozzle member 70, and it is provided further to the outer side than the liquid supply port 12 with respect to the optical axis AX of the projection optical system PL (optical element LS). In addition, an internal flow passage that connects the recovery pipe 23 and the liquid recovery port 22 is provided at the interior of the nozzle member 70.

Operations of the liquid supply part 11 are controlled by the control apparatus CONT. When the liquid LQ is supplied onto the substrate P, the control apparatus CONT sends out the liquid LQ from the liquid supply part 11 and supplies the liquid LQ onto the substrate P from the liquid supply port 12 provided above the substrate P via the supply pipe 13 and the internal flow passage of the nozzle member 70. In addition, the liquid recovery operation of the liquid recovery part 21 is controlled by the control apparatus CONT. The control apparatus CONT is able to control the amount of liquid recovered per unit time by the liquid recovery part 21. The liquid LQ on the substrate P recovered from the liquid recovery port 22 provided above the substrate P is recovered by the liquid recovery part 21 via the internal flow passage of the nozzle member 70 and the recovery pipe 23.

The control apparatus CONT forms a liquid immersion area AR2, that is larger than the projection area AR1 and smaller than the substrate P, on at least a portion of the substrate P that includes the projection area AR1 of the projection optical system PL using the liquid LQ supplied from a liquid supply mechanism 10 at least while the pattern image of the mask M is being projected onto the substrate P. Specifically, the exposure apparatus EX fills the space between the optical element LS of the front end of the image plane side of the projection optical system PL and the upper surface Pa of the substrate P held on the substrate holder PH with the liquid LQ, to locally form the liquid immersion area AR2 on the substrate P. Then, the control apparatus CONT projects the pattern image of the mask M onto the substrate P via the projection optical system PL and the liquid LQ of the liquid immersion area AR2 by radiating the exposure light EL to the substrate P held on the substrate holder PH, and it exposes this substrate P.

In the present embodiment, pure water or purified water is used as the liquid LQ that forms the liquid immersion area AR2. Pure water is capable of transmission even if the exposure light EL is ArF excimer laser light. In addition, pure water is also able to transmit deep ultraviolet light (DUV light) such as ultraviolet band bright lines (g-rays, h-rays, i-rays) and KrF excimer laser light (wavelength of 248 nm).

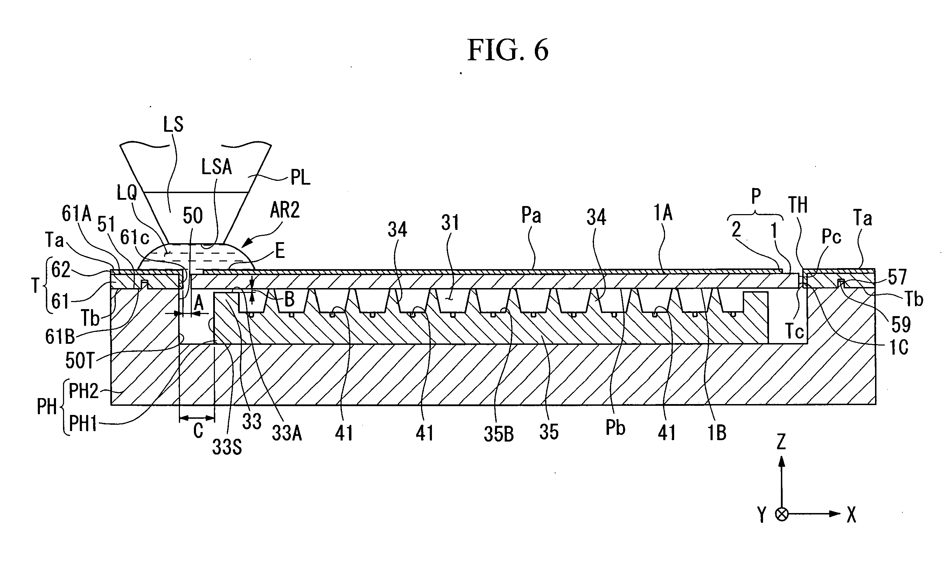

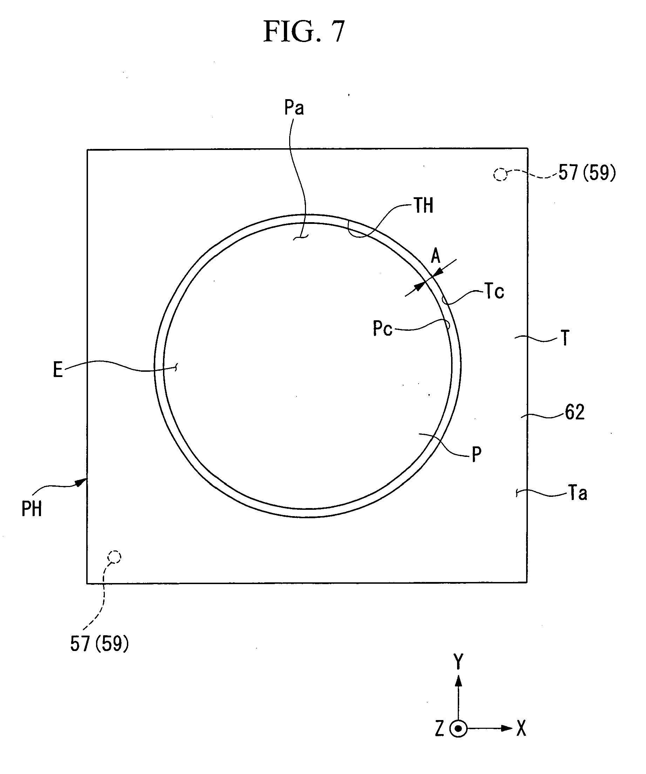

FIG 6 is a side cross sectional view that shows a substrate holder PH in a status in which a substrate P is held, and FIG. 7 is a plan view. In FIG. 6, the substrate holder PH comprises the first holder part PH1, which is for holding the substrate P, and the second holder part PH2, which is for holding the plate member T. An opening part TH is formed on the plate member T, and the plate member T is held on the second holder part PH2 so as to surround the substrate P held on the first holder part PH1. The substrate holder PH has a concave or recess part 50 at the inner side of the second holder part PH2, and the first holder part PH1 is provided at the inner side of the concave part 50. In addition, the plate member T is held on the upper surface 51 of the second holder part PH2. Note that, in the figure, the first holder part PH1 and the second holder part PH2 are shown as separate members, but the first holder part PH1 and the second holder part PH2 may also be formed as a integral body. In addition, the substrate P shown in FIG. 6 is equivalent to the substrate P explained while referring to FIG. 1A and FIG. 1B.

The first holder part PH1 comprises a base member 35, which has a bottom surface 35B, which opposes the lower surface Pb of the substrate P and is separated from the lower surface Pb of the substrate P by a specified distance, a peripheral wall part 33, which is formed on the base member 35 and has an upper surface 33A that opposes the lower surface Pb of the substrate P, and support parts 34, which are formed on the bottom surface 35B of the inner side of the peripheral wall part 33. The peripheral wall part 33 is formed in a nearly annular shape to match the shape of the substrate P. The upper surface 33A of the peripheral wall part 33 is formed so as to oppose the edge part of the lower surface Pb of the substrate P. In addition, the upper surface 33A of the peripheral wall part 33 is a flat surface.

The support parts 34 of the first holder part PH1 are uniformly provided at the inner side of the peripheral wall part 33. In the present embodiment, the support parts 34 of the first holder part PH 1 include a plurality of support pins, and the first holder part PH1 forms at least a portion of a so-called pin chuck mechanism. The pin chuck mechanism, which includes the first holder part PH1, comprises a suction mechanism including suction ports 41 which bring a space 31 surrounded by the base member 35 of the first holder part PH 1, the peripheral wall part 33, and the substrate P to a negative pressure, and the substrate P is chuck held by the support parts 34 by providing the space 31 with a negative pressure. The suction ports 41 are provided on the bottom surface 35B of the base member 35. In addition, the control apparatus CONT releases the chuck holding of the first holder part PH1 to the substrate P by canceling the negative pressure of the space 31. Specifically, the substrate P is removably and attachably held with respect to the first holder part PH1.

The second holder part PH2 has an upper surface 51, which supports the lower surface Tb of the plate member T. An opening part TH, which conforms to the size and shape of the substrate P, is formed at the center part of the plate member T, and the upper surface 51 has nearly the same shape as the lower surface Tb of the plate member T. Convex parts 57 are formed at a plurality of specified positions of the upper surface 51, and concave parts 59 are formed at a plurality of specified positions of the lower surface Tb of the plate member T to correspond to the convex parts 57. Note that, as shown in FIG 7, in the present embodiment, the convex parts 57 and the concave parts 59 that correspond to those convex parts 57 are provided at two locations, but they may also be provided at any plurality of locations. In addition, by arranging the convex parts 57 at the inner side of the concave parts 59, specifically by engaging the convex parts 57 and the concave parts 59, holding is performed in a status in which the plate member T is positioned and held on the upper surface 51 of the second holder part PH2. In addition, by releasing the engagement of the convex parts 57 and the concave parts 59, it is possible to separate the plate member T and the second holder part PH2. Specifically, the plate member T is removably and attachably held with respect to the second holder part PH2.

Note that the work for separating the plate member T from the second holder PH2 is periodically performed during, for example, apparatus maintenance work.

In addition, the external shape (size) of the plate member T may also be made larger than the external shape of the substrate holder PH (second holder part PH2).

The plate member T has a base material 61 and a film 62 which covers the upper surface 61 A and the inner side surface 61C of the base material 61. The film 62 is formed of a liquid repellent material such as, for example, a fluorine resin material or an acrylic resin material. With this configuration, the upper surface Ta and the inner side surface Tc of the plate member T, which is provided with that film 62, have liquid repellency with respect to the liquid LQ. It is preferable that a material that is insoluble in the liquid LQ be used as the liquid repellent material for forming the film 62. Note that the base material 61 may also be formed of a liquid repellent material such as a fluorine resin material or an acrylic resin material. In that case, it is possible to form a plate member T that has liquid repellency without providing the film 62 on the upper surface 61 A or on the inner side surface 61C of the base material 61.

Here, in the present embodiment, the upper surface Ta of the plate member T refers to the surface of the material film of the uppermost layer among the material film coated onto the upper surface 61A of the base material 61. Therefore, as in the example shown in FIG. 6, the upper surface Ta of the plate member T is the surface of the film 62 formed by the liquid repellent material. In the same way, the inner side surface Tc of the plate member T refers to the surface of the material film of the uppermost layer among the material film coated onto the inner side surface 61C of the base material 61. Therefore, in the example shown in FIG 6, the inner side surface Tc of the plate member T is the surface of the film 62 formed by the liquid repellent material. In addition, in the case in which a film is not coated onto the inner side surface 61C of the base material 61 of the plate member T, the inner side surface Tc of the plate member T is the inner side surface 61C of the base material 61. Similarly, in the case where a film is not coated onto the upper surface 61 A of the base material 61 of the plate member T, the upper surface Ta of the plate member T is the upper surface 61 A of the base material 61. In addition, the lower surface Tb of the plate member T refers to the surface of the material film of the lowermost layer among the material film coated onto the lower surface 61 B of the base material 61. In the example shown in FIG. 6, a material film is not provided on the lower surface 61 B of the base material 61, and the lower surface 61 B of the base material 61 is the lower surface Tb of the plate member T.

In addition, in the present embodiment, the upper surface Pa of the substrate P refers to the surface of the material film of the uppermost layer from among the material film coated onto the upper surface 1 A of the base material 1. Therefore, in the example shown in FIG. 6, the upper surface Pa of the substrate P is the surface of the film formed by the photosensitive material 2. In addition, as explained while referring to FIG. 3 and FIG. 4, in the case in which a top coat film 3 is provided on the photosensitive material 2, the surface of that top coat film 3 is the upper surface Pa of the substrate P. Similarly, the outside surface Pc of the substrate P refers to the surface of the material film of the uppermost layer among the material film coated onto the side surface 1C of the base material 1. Therefore, in the example shown in FIG. 6, the material film is not coated onto the side surface 1C of the base material 1, so the outer side surface Pc of the substrate P is the side surface 1C of the base material 1. In addition, in the substrate P explained while referring to FIG. 2, the outer side surface Pc of the substrate P is the surface of the film formed by the photosensitive material 2, and in the substrate P explained while referring to FIG. 3 and FIG. 4, the outer side surface Pc of the substrate P is the surface of the top coat film 3. In addition, the lower surface Pb of the substrate P refers to the surface of the material film of the lowermost layer among the material film coated onto the lower surface 1B of the base material 1. In the example shown in FIG. 6, a material film is not provided on the lower surface 1B of the base material 1, and the lower surface 1B of the base material 1 is the lower surface Pb of the substrate P.

The plate member T is held by the second holder part PH2 of the substrate holder PH. In addition, the substrate P is arranged on the substrate holder PH (first holder part PH1) so that the inner side surface Tc of the opening part TH of the plate member T on the second holder part PH2 and the outer side surface Pc of the substrate P oppose each other.

In addition, the upper surface Ta of the plate member T is a nearly flat surface, and the upper surface Pa of the substrate P held by the first holder part PH1 and the upper surface Ta of the plate member T held by the second holder part PH2 are nearly flush.

A gap A that has been set to 0.3 mm or less is formed between the outer side surface Pc of the substrate P held by the substrate holder PH and the inner side surface Tc of the opening part TH of the plate member T provided in the periphery of that substrate P. In addition, a gap C that has a specified distance is provided between the inner side surface 50T of the concave part 50, in which the first holder part PH1 is arranged, and the outer side surface 33S of the peripheral wall part 33. The outer diameter of the peripheral wall part 33 is formed to be smaller than the outer diameter of the substrate P, and gap C is larger than gap A, at approximately 1.5 mm, for example.

In addition, in the present embodiment, the upper surface 33A of the peripheral wall part 33 is a flat surface, and that upper surface 33A is coated with a liquid repellent material such as a fluorine resin material and has liquid repellency. In addition, a specified gap B is provided between the upper surface 33A and the rear surface Pb of the substrate P. In addition, in the present embodiment, the outer side surface 33S of the peripheral wall part 33 and the inner side surface 50T of the second holder part PH2 of the substrate holder PH are also covered by the above mentioned liquid repellent material and have liquid repellency. In addition, the surfaces of the support parts 34, and the surface of the base member 35, which includes the bottom surface 35B, also have liquid repellency.

Note that, in the present embodiment, the upper surface 33A, the outer side surface 33S, the inner side surface 50T, the surfaces of the support parts 34, and the surface of the base material 35 are coated with a liquid repellent material, but alternatively only a portion of these may be coated, and any of them may not be coated.

On the other hand, the liquid contact surface (including the lower surface LSA) that comes into contact with the liquid LQ of the liquid immersion area AR2 of the optical element LS has lyophilicity with respect to the liquid LQ. In addition, the liquid contact surface (including the lower surface 70A) of the nozzle member 70 that comes into contact with the liquid LQ of the liquid immersion area AR2 also has lyophilicity with respect to the liquid LQ. In order to make the liquid contact surfaces of the aforementioned optical element LS and nozzle member 70 lyophilic, in the present embodiment, lyophilization treatment, in which a lyophilic material such as, for example, $MgF_2$, $Al_2O_3$ or $SiO_2$ is coated onto the liquid contact surface, is performed. Note that, a material that is insoluble with respect to the liquid LQ is used as the material provided on the optical element LS, nozzle member 70, etc.

Exposure Method

Next, a method of exposing the substrate P using the exposure apparatus EX having a configuration discussed above will be explained.

First, the substrate P, which is subject to exposure processing, is loaded onto the first holder part PH1 of the substrate holder PH by the loader apparatus 150. Lift pins that are not shown in the drawing are provided on the first holder part PH1, and when the substrate P is loaded, the control apparatus CONT raises those lift pins so that the upper end parts of the lift pins protrude further to the upper side than the upper surface Ta of the plate member T. The loader apparatus 150 withdraws from the substrate holder PH after the substrate P has been placed on the upper end parts of those lift pins. The control apparatus CONT holds the substrate P that has been passed from the loader apparatus 150 at the upper end parts of the lift pins, and it lowers those lift pins. Through the lowering of the lift pins, the lower surface Pb of the substrate P is supported by the support parts 34. After the lower surface Pb of the substrate P has been supported by the support parts 34, the control apparatus CONT drives the suction mechanism, which includes the suction ports 41, and brings the space 31 to a negative pressure to chuck hold the substrate P using the support parts 34.

After the substrate P has been held by the substrate holder PH (first holder part PH1), the control apparatus CONT drives the liquid immersion mechanism 100 to form the liquid immersion area AR2 of the liquid LQ so as to cover the projection area AR1 between the projection optical system PL and the substrate P. Then, the control apparatus CONT radiates the exposure light EL onto the substrate P via the projection optical system PL and the liquid LQ in a status in which the substrate P is held on the substrate holder PH (first holder part PH1) to expose the substrate P. Through this, the pattern image of the mask M is projected onto the upper surface Pa of the substrate P. Then, after exposure processing for the first substrate P has been completed, that first substrate P is unloaded from the substrate holder PH, and a new second substrate P is loaded onto the substrate holder PH to be exposure processed. In this way, a plurality of substrates P is sequentially loaded onto the substrate holder PH, and liquid immersion exposure processing is sequentially performed on those respective loaded substrates P.

As shown in FIG. 5, the lower surface LSA of the optical element LS of the projection optical system PL and the lower surface 70A of the nozzle member 70 respectively are flat surfaces, and the lower surface LSA of the optical element LS of the projection optical system PL and the lower surface 70A of the nozzle member 70 are nearly flush. In addition, as discussed above, the upper surface Pa of the substrate P held by the first holder part PH1 and the upper surface Ta of the plate member T held by the second holder part PH2 are nearly flush. With this configuration, it is possible to form the liquid immersion area AR2 well between the lower surface 70A of the nozzle member 70 and the lower surface LSA of the optical element LS and the upper surface Pa of the substrate P and the upper surface Ta of the plate member T.

In addition, when the exposure light EL is radiated to the edge area E of the upper surface Pa of the substrate P via the liquid LQ to project the pattern image of the mask M or when the liquid immersion area AR2 is moved from the upper surface Pa of the substrate P to the upper surface Ta of the plate member T, as shown in FIG. 6, a case occurs in which a portion of the liquid immersion area AR2 is formed on the plate member T outside the substrate P. In the present embodiment, the upper surface Ta of the plate member T, which is nearly flush with the upper surface Pa of the substrate P, is arranged in the vicinity of the substrate P, so even when liquid immersion exposure of the edge area E of the substrate P is performed, it is possible to retain the liquid LQ on the image plane side of the projection optical system PL to form the liquid immersion area AR2 well. In addition, by making the upper surface Pa of the substrate P and the upper surface Ta of the plate member T liquid repellent, it is possible to maintain the liquid immersion area AR2 well, and it is possible to prevent the nonconformity whereby the liquid LQ remains on the upper surface Pa of the substrate P and the upper surface Ta of the plate member T.

In addition, as shown in FIG. 6, in the case where the liquid immersion area AR2 of the liquid LQ is formed on gap A, there is a possibility that the liquid LQ will penetrate between the substrate P and the plate member T via gap A. There is a possibility that the liquid LQ that has penetrated via gap A will penetrate to the lower surface Pb of the substrate P and will penetrate between the substrate P and the substrate holder PH. In any case, in the present embodiment, since the upper surface Ta and the inner side surface Tc of the plate member T are liquid repellent, it is possible to prevent (or restrict) penetration of the liquid LQ via gap A. In addition, by also coating the outer side surface Pc of the substrate P with a liquid repellent material (photosensitive material 2, top coat film 3) to make it liquid repellent, it is possible to more reliably prevent penetration of the liquid LQ via gap A.

In addition, in the present embodiment, a substrate P in which the dimensional tolerance $D_P$ of the outer diameter $L_P$ is $\pm 0.02$ mm or less is used. Therefore, it is possible to prevent interference between the substrate P and the plate member T when the substrate P is loaded onto the substrate holder PH, and it is possible to set the gap A to a predetermined value or less (0.3 mm or less) after loading. Furthermore, even if the liquid immersion area AR2 is formed on gap A in the vicinity of the substrate P, it is possible to maintain the status of the liquid immersion area AR2 well while preventing (restricting) penetration, etc. of the liquid from gap A. In this case, when determining the dimensional tolerance $D_P$ of the outer diameter $L_P$ of the substrate P, it is possible to set the tolerance values of the various positioning accuracies, shape accuracies, etc. of the exposure apparatus EX with some leeway by taking into account (a) the dimensional tolerance $D_T$ of the inner diameter $L_T$ of the plate member T, (b) the attachment accuracy of the plate member T, (c) the loading position accuracy of the loader apparatus 150, (d) the reset repeatability of the substrate stage apparatus PST, etc.

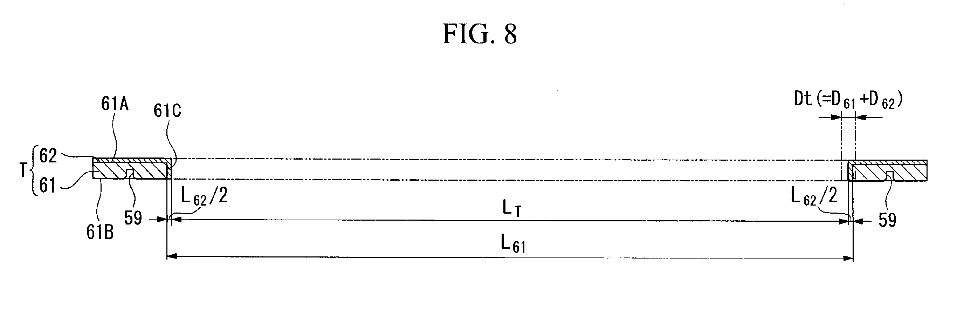

Here, "(a) the dimensional tolerance $D_T$ of the inner diameter $L_T$ of the plate member T" refers to the dimensional tolerance $D_T$ of the inner diameter $L_T$ of the inner side surface T of the plate member T. In the present embodiment, since a liquid repellent film 62 is provided at the inner side surface Tc of the plate member T, as shown in FIG. 8, the inner diameter $L_T$ of the plate member T is a value resulting from subtracting, from the inner diameter $L_{61}$ of inner side surface 61C of the base material 61, the film thickness $L_{62}$ of the film 62 that has been coated onto that inner side surface 61C (specifically, $L_T = L_{61} - L_{62}$). In addition, the dimensional tolerance $D_T$ of the inner diameter $L_T$ of the plate member T is the sum of the dimensional tolerance $D_{61}$ of the inner diameter $L_{61}$ of the base material 61 and the dimensional tolerance $D_{62}$ of the film thickness $L_{62}$ of the film 62 (specifically, $D_T = D_{61} + D_{62}$). Note that in the case where a film is not coated onto the inner side surface Tc of the plate member T (the inner side surface 61C of the base material 61), the inner diameter $L_T$ of the plate member T is the inner diameter $L_{61}$ of the inner side surface 61C of the base material 61, and the dimensional tolerance $D_T$ of the inner diameter $L_T$ of the plate member T is the dimensional tolerance $D_{61}$ of the inner diameter $L_{61}$ of the base material 61.

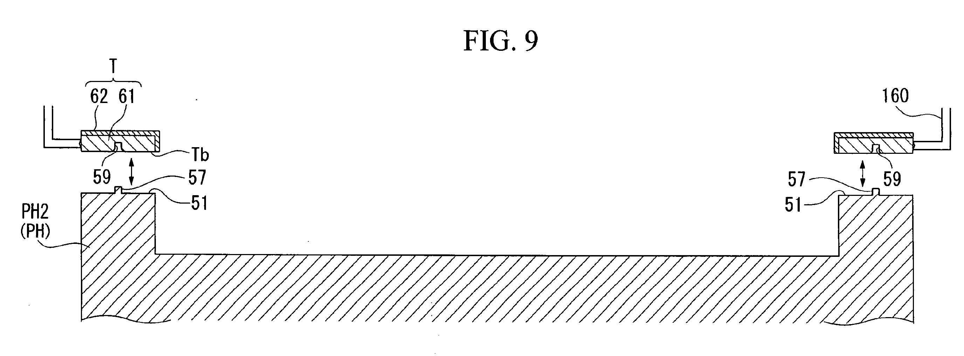

In addition, "(b) the attachment accuracy of the plate member T" refers to the positioning accuracy of the plate member T with respect to an ideal position on the substrate holder PH (second holder part PH2). As discussed above, the plate member T can be removed from and attached to the substrate holder PH (second holder part PH2), and when the plate member T is attached to the substrate holder PH, as shown in FIG. 9, the plate member T is installed on the upper surface 51 of the second holder part PH2 by means of a conveyance apparatus 160 (or an operator) that has, for example, a robot arm. Then, by engaging the convex parts 57 provided on the upper surface 51 of the second holder part PH2 with the concave parts 59 provided on the lower surface Tb of the plate member T, the plate member T is positioned with respect to the second holder part PH2. In this case, there is a possibility that the position of the plate member T will be shifted with respect to the ideal position on the substrate holder PH (second holder part PH2) due to engagement error between the convex parts 57 and the concave parts 59, the conveyance position accuracy of the conveyance apparatus 160, etc. Therefore, in the present embodiment, that positioning accuracy of the plate member T with respect to the ideal position is called "(b) the attachment accuracy of the plate member T. " In addition, in the explanation below, position error of the plate member T with respect to the ideal position on the substrate holder PH (second holder part PH2) is appropriately called "plate position error $D_{57}$. "

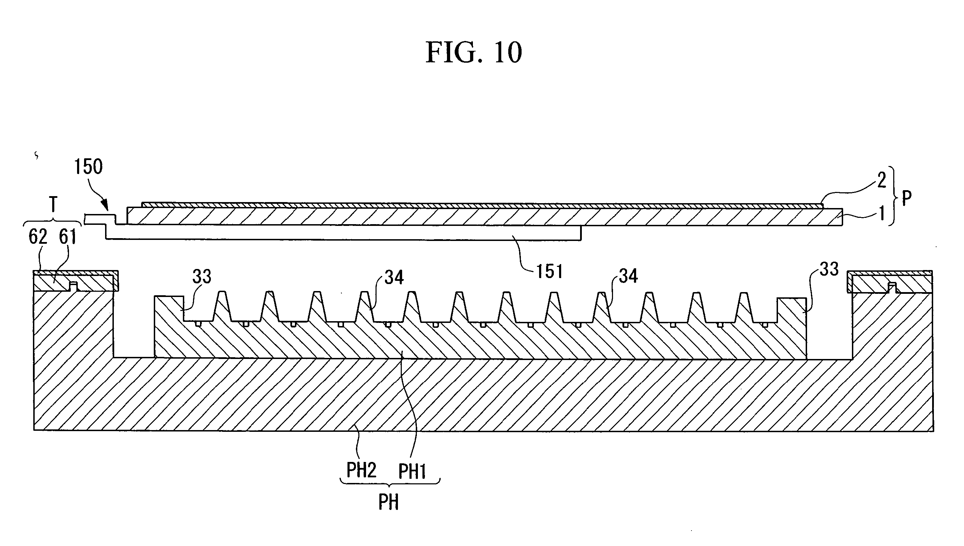

In addition, "(c) the loading position accuracy of the loader apparatus 150" refers to the position accuracy of loading of the substrate P onto the substrate holder PH by the loader apparatus 150. As shown by the schematic drawing in FIG. 10, the substrate P is loaded to the substrate holder PH by the loader apparatus 150. In this case, when the loader apparatus 150 loads the substrate P onto the substrate holder PH, there is a possibility that the loading position will be shifted with respect to an ideal position due to, for example, feed error of the arm 151, which holds the substrate P, of the loader apparatus 150, positional alignment error when the arm 151 holds the substrate P, or vibration that is transmitted from installation surface (floor surface) on which the exposure apparatus EX, which includes the loader apparatus 150 and the substrate holder PH (substrate stage apparatus PST), is set up. Therefore, in the present embodiment, that position accuracy of loading of the substrate P on the substrate holder PH by the loader apparatus 150 is referred to as "(c) the loading position accuracy of the loader apparatus 150." In addition, in the explanation below, the position error of loading of the substrate P onto the substrate holder PH by the loader apparatus 150 is appropriately referred to as "loader error $D_{150}$. "

In addition, "(d) the reset repeatability of the substrate stage apparatus PST" refers to the positioning accuracy when the substrate holder PH is positioned with respect to an ideal position after initialization of the substrate stage apparatus PST has been performed. In the exposure apparatus EX, initialization (resetting) of the substrate stage apparatus PST is performed at start up of the apparatus, such as after maintenance work has ended or after recovery operation has ended. Then, after initialization has been performed, the operation of positioning the substrate holder PH with respect to an ideal position (position recovery work) is performed. Note that, the positioning operation of the substrate holder PH is performed using a physical technique, such as one in which a portion of the substrate stage apparatus is brought into contact with a prescribed member, or an optical technique that uses an alignment optical system, etc., for example. In any event, even in the case where such positioning operation has been performed, there is a possibility that positioning the substrate holder PH with respect to the ideal position cannot always be performed each time initialization (resetting), and there is a possibility that good repeatability cannot be achieved. Therefore, in the present invention, the positioning accuracy when the substrate holder PH has been positioned with respect to the ideal position each time when initialization of the substrate stage apparatus PST has been performed is referred to as "(d) the reset repeatability of the substrate stage apparatus PST. " In addition, in the explanation below, error in positioning of the substrate holder PH with respect to the ideal position after the positioning operation has been performed after initialization of the substrate stage apparatus PST has been performed is appropriately referred to as "reset position error $D_{PST}$- "

Also, if it is possible to set the dimensional tolerance $D_P$ of the outer diameter $L_P$ of the substrate P, the dimensional tolerance $D_T$ of the inner diameter $L_T$ of the plate member T, the plate position error $D_{57}$, the loader error $D_{150}$, and the reset position error $D_{PST}$ to an ideal status (zero) respectively, it will be possible to prevent interference between the substrate P and the plate member T when the substrate P is loaded onto the substrate holder PH while setting gap A after loading to nearly zero. In addition, supposing it is possible to set the dimensional tolerance $D_T$ of the inner diameter $L_T$ of the plate member T, the plate position error $D_{57}$, the loader error $D_{150}$, and the reset position error $D_{PST}$ to an ideal status (zero) respectively, a dimensional tolerance $D_P$ of the outer diameter $L_P$ of the substrate P of - 0.3 mm will suffice to set gap A to 0.3 mm or less. In any event, it is extremely difficult to set the dimensional tolerance $D_T$ of the inner diameter $L_T$ of the plate member T, the plate position error $D_{57}$, the loader error $D_{150}$, and the reset position error $D_{PST}$ respectively to an ideal status (zero).

Therefore, in the present embodiment, the dimensional tolerance $D_P$ of the outer diameter $L_P$ of the substrate P is determined while taking (a) to (d) above into account. Specifically, realizable values are respectively determined for the dimensional tolerance $D_T$ of the inner diameter $L_T$ of the plate member T, the plate position error $D_{57}$, the loader error $D_{150}$, and the reset position error $D_{PST}$ respectively, and the dimensional tolerance $D_P$ of the outer diameter $L_P$ of the substrate P is determined while taking those values into account.

Here, the condition in which the substrate P and the plate member T do not interfere with each other when the substrate P is loaded onto the substrate holder PH is:

$$(L_T - D_T) - (L_P + D_P) - D_{57} - D_{150} - D_{PST} > 0 \qquad \ldots(1)$$

In addition, the condition in which gap A is 0.3 mm or less after the substrate P has been loaded onto the substrate holder PH is:

$$(L_T + D_T) - (L_P - D_P) + D_{57} + D_{150} + D_{PST} \leq 0.6 \qquad …(2)$$

With respect to the dimensional tolerance $D_T$ of the inner diameter $L_T$ of the plate member T changes occur according to various conditions such as the material that forms the plate member T and the material of the coated film 62, but a realizable value among those is determined. In addition, with respect to the plate position error $D_{57}$ as well, changes occur according to the structure, etc. of the holding mechanism of the second holder part PH2 for the plate member T, but a realizable value among those is determined. In addition, with respect to the loader error $D_{150}$ as well, changes occur according to the environment in which the exposure apparatus EX is placed and accuracy disparities among the models of loader apparatuses 150, but a realizable value among those is determined. Similarly, with respect to the reset position error $D_{PST}$ as well, changes occur according to the respective conditions, but a realizable value among those is determined. $\pm 0.02$ mm or less (and preferably $\pm 0.01$ mm or less) is set as the dimensional tolerance $D_P$ of the outer diameter $L_P$ of the substrate P which satisfies Equation (1) and Equation (2) above while taking into account the respective realizable values of the dimensional tolerance $D_T$ of the inner diameter $L_T$ of the plate member T, the plate position error $D_{57}$, the loader error $D_{150}$, and the reset position error $D_{PST}$ determined in this way. Through this, it is possible to load the substrate P without causing the substrate P and the plate member T to interfere with each other, and, after the substrate P has been loaded, it is possible to obtain a gap A of a prescribed value or less (0.3 mm or less) to the extent that the liquid LQ does not penetrate.

As explained above, in the case where the liquid immersion area AR2 is formed in order to expose the substrate P based on the liquid immersion method, it is possible to maintain gap A between the outer surfaces Pc of the respective substrates P of the plurality that is sequentially loaded onto the substrate holder PH and the inner side surface Tc of the plate member T at a predetermined value or less by providing the plate member T so as to surround the vicinity of the substrate P and setting the dimensional tolerance $D_P$ of the outer diameter $L_P$ of the substrate P to $\pm 0.02$ mm or less in order to maintain status of that liquid immersion area AR2. Therefore, it is possible to restrict the liquid LQ from penetrating via gap A, and it is possible to prevent penetration of the liquid LQ to the rear surface Pb side of the substrate P. In addition, by setting the dimensional tolerance $D_P$ of the outer diameter $L_P$ of the substrate P to $\pm 0.02$ mm or less, even when a plurality of substrates P is sequentially loaded onto the substrate holder PH, it is possible to prevent interference between the substrate P and the substrate holder PH, which includes the plate member T, without strictly setting tolerance values of the various positioning accuracies and shape accuracies of the exposure apparatus EX. Therefore, it is possible to prevent damage to the substrate P and the substrate holder PH, which includes the plate member T, while holding the substrate P on the substrate holder PH well.

In a dry type exposure apparatus that exposes a substrate not through a liquid, it is not necessary to arrange a plate member in the vicinity of the substrate on the substrate holder, and, even if the dimensional tolerance of the outer diameter of the substrate to be exposed by the dry type exposure apparatus were set relatively roughly to approximately $\pm 0.1$ mm for example, the effect on exposure processing would be small. However, in the liquid immersion exposure apparatus EX that exposes the substrate P through the liquid LQ, the plate member T is arranged in the vicinity of the substrate P on the substrate holder PH to maintain the status of the liquid immersion area AR2, and in order to prevent the liquid from penetrating to the rear surface Pc side of the substrate P, it is preferable that gap A between the plate member T and the substrate P be set to a predetermined value or less. In order to set the gap A to a predetermined value or less, it is also necessary to strictly set tolerance values such as the dimensional tolerance $D_T$ of the inner diameter $L_T$ of the plate member T, the plate position error $D_{57}$, the loader error $D_{150}$, and the reset position error $D_{PST}$ as the various positioning accuracies and shape accuracies of the exposure apparatus EX, but as discussed above, they are limited. Therefore, by setting the dimensional tolerance $D_P$ of the outer diameter Lp of the substrate P to be exposed by the liquid immersion method more strictly than the dimensional tolerance of the outer diameter of the substrate to be exposed by a dry type exposure apparatus, it is possible to prevent interference between the substrate P and the substrate holder PH (plate member T) when loading is performed, and it is possible to set gap A between the loaded substrate P and the plate member T to a predetermined value or less while having leeway in tolerance values such as the dimensional tolerance $D_T$ of the inner diameter $L_T$ of the plate member T, the plate position error $D_{57}$, the loader error $D_{150}$, and the reset position error $D_{PST}$.

Note that, in the embodiment discussed above, the plate member T that forms the flat part in the vicinity of the substrate P is removably and attachably held by the substrate holder PH, but it is also possible to form the flat part formed in the vicinity of the substrate P using the substrate holder PH. In this case as well, in the same way as the case in which the respective errors relating to the plate member are taken into account, the respective errors such as those of the dimensions of the substrate holder PH may be taken into account.

As discussed above, the liquid LQ in the present embodiment is pure water. Pure water has advantages in that it can be easily obtained in large quantity at semiconductor fabrication plants, etc. and in that it has no adverse effects on the photosensitive material on the substrate P or on the optical elements (lenses), etc. In addition, pure water has no adverse effects on the environment and contains very few impurities, so one can also expect an action whereby the surface of the substrate P and the surface of the optical element arranged on the front end of the projection optical system PL are cleaned. Note that, in the case where the purity of the pure water supplied from the plant, etc. is low, the exposure apparatus may have ultra pure water manufacturing equipment.

In addition, the index of refraction n of pure water (water) with respect to exposure light EL with a wavelength of approximately 193 nm is said to be nearly 1.44, so in the case where ArF excimer laser light (193 nm wavelength) is used as the light source of the exposure light EL, on the substrate P, it is possible to shorten the wavelength to 1/n, that is, approximately 134 nm, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

Note that, when a liquid immersion method such as that discussed above is used, the numerical aperture NA of the projection optical system may become 0.9 to 1.3. In this way, in the case in which the numerical aperture NA of the projection optical system becomes larger, image formation performance may deteriorate due to a polarization effect with the random polarized light conventionally used as the exposure light. Therefore, it is preferable that polarized light illumination be used. In that case, linear polarization illumination to match the lengthwise direction of the line pattern of the line and space pattern of the mask (reticle) is performed, and refracted light of the S polarization component (TE polarization component), that is, the polarization direction component along the lengthwise direction of the line pattern, may be emitted from the mask (reticle) pattern in large quantities. In the case in which the space between the projection optical system PL and the photosensitive material coated onto the upper surface of the substrate P (base material 1) is filled with a liquid, the transmittivity of the refracted light of the S polarization component (TE polarization component) at the photosensitive material surface, which contributes to the improvement of contrast, is higher than that of the case in which the space between the projection optical system PL and the photosensitive material coated onto the upper surface of the substrate P (base material 1) is filled with air (gas), so high image formation performance can be obtained even in such cases as when the numerical aperture NA of the projection optical system exceeds 1.0. In addition, it is even more effective when a phase shift mask or a grazing incidence illumination method (particularly, the dipole illumination method) matching the lengthwise direction of the line pattern such as that disclosed in Japanese Unexamined Patent Application Publication No. H6-188169 is appropriately combined. In particular, a combination of the linear polarization illumination method and the dipole illumination method is effective in the case in which the circumferential direction of the line and space pattern is limited to a prescribed direction and in the case in which the hole pattern is densely concentrated along a prescribed direction. For example, in the case in which a halftone type phase shift mask with a transmittivity of 6% (pattern with a half pitch of approximately 45 nm) is illuminated by jointly using the linear polarization illumination method and the dipole illumination method, when the illumination σ defined at the circumscribed circle of the two light beams that form the dipole at the pupil plane of the illumination system is 0.95, the radius of the respective light beams at that pupil plane is 0.125σ, and the numerical aperture of the projection optical system PL is NA = 1.2, it is possible to increase depth of focus (DOF) approximately 150 nm more than when random polarized light is used.

In addition, for example, in the case where an ArF excimer laser is used as the exposure light, and a projection optical system PL with a reduction rate of approximately 1/4 is used to expose a fine line and space pattern (for example, lines and spaces of approximately 25 to 50 nm) onto the substrate P, depending on the structure of the mask M (for example, the degree of fineness of the pattern and the thickness of the chrome), the mask M acts as a polarization plate due to the wave guide effect, and more refracted light of the S polarization component (TE polarization component) emerges from the mask M than refracted light of the P polarization component (TM polarization component), which reduces contrast. In this case, it is preferable that the linear polarization illumination discussed above be used, but even in the case in which the numerical aperture NA of the projection optical system PL is large at 0.9 to 1.3 even though the mask M is illuminated by random polarized light, it would be possible to obtain high resolution performance.

In addition, in a case such as one where an extremely fine line and space pattern on the mask M is exposed onto the substrate P, there is a possibility that the P polarization component (TM polarization component) will be larger than the S polarization component (TE polarization component) due to the wire grid effect, but, for example, if the conditions are such that ArF excimer laser light is used as the exposure light, and a projection optical system PL with a reduction rate of approximately 1/4 is used to expose a line and space pattern larger than 25 nm onto the substrate P, more refracted light of the S polarization component (TE polarization component) will emerge from the mask than refracted light of the P polarization component (TM polarization component), so it would be possible to obtain high resolution performance even in the case in which the numerical aperture NA of the projection optical system PL becomes large at 0.9 to 1.3.

In addition, as disclosed in Japanese Unexamined Patent Application Publication No. H6-53120, not only linear polarization illumination (S polarization illumination) that matches the lengthwise direction of the line pattern of the mask (reticle) but a combination of a polarization illumination method that linearly polarizes in the tangential (circumferential) direction of a circle centering on the optical axis and the grazing incidence method is also effective. In particular, in the case where not only a line pattern in which the pattern of the mask (reticle) extends in one prescribed direction but a line pattern that extends in a plurality of different directions are intermingled (line and space patterns with different circumferential directions are intermingled), as disclosed in the same Japanese Unexamined Patent Application Publication No. H6-53120, by jointly using a polarization illumination method that linearly polarizes in the tangential direction of a circle centering on the optical axis and the zonal illumination method, it is possible to obtain high resolution performance even in the case in which the numerical aperture NA of the projection optical system is large. For example, in the case where illumination of a halftone type phase shift mask with a transmittivity of 6% (pattern with a half pitch of approximately 63 nm) is performed by jointly using a polarization illumination method that linearly polarizes in the tangential direction of a circle centering on the optical axis and the zonal illumination method (zone ratio 3/4), when the illumination σ is 0.95, and the numerical aperture of the projection optical system PL is NA = 1.00, it is possible to increase the depth of focus (DOF) by approximately 250 nm over when random polarized light is used, and, at a numerical aperture of the projection optical system of NA = 1.2 with a pattern with a half pitch of approximately 55 nm, it is possible to increase the depth of focus by approximately 100 nm.

Furthermore, it would also be effective to apply the progressive focus exposure method disclosed in, for example, Japanese Unexamined Patent Application Publication No. H4-277612 or Japanese Unexamined Patent Application Publication No. 2001-345245.

In the present embodiment, an optical element LS is attached to the front end of the projection optical system PL, and it is possible to perform adjustment of the optical characteristics of the projection optical system PL, for example, aberration (spherical aberration, coma aberration, etc.) by means of this lens. Note that the optical element attached to the front end of the projection optical system PL may be an optical plate used in the adjustment of the optical characteristics of the projection optical system PL. Or it may be a parallel flat surface plate that is able to transmit the exposure light EL.

Note that, in the case where the pressure between the optical element of the front end of the projection optical system PL and the substrate P generated by the flow of the liquid LQ is large, the optical element may be firmly secured so that it does not move by means of that pressure without making it possible to replace that optical element.

Note that, in the present embodiment, it is a configuration in which the space between the projection optical system PL and the upper surface of the substrate P is filled with the liquid LQ, but it may also be a configuration in which the liquid LQ is filled in a status in which a cover glass consisting of parallel flat surface plates has been attached to the upper surface of the substrate P, for example. In addition, the exposure apparatus discussed above that applies a liquid immersion method has a configuration that exposes the substrate P by filling the optical path space of the emergence side of the optical element LS of the projection optical system PL with a liquid (pure water), but as disclosed in PCT International Publication No. WO 2004/019128, the optical path space of the incidence side of the optical element LS of the projection optical system PL may also be filled with a liquid (pure water).

Note that the liquid LQ of the present embodiment is water, but it may be a liquid other than water, for example, in the case where the light source of the exposure light EL is an $F_2$ laser, this $F_2$ laser light does not pass through water, so the liquid LQ may be a fluorine group fluid such as perfluoropolyether (PFPE) or fluorine oil that is able to transmit $F_2$ laser light. In this case, lyophilization treatment is performed by forming a thin film using a substance with the molecular structure with a small polarity that includes, for example, fluorine at the portion that comes into contact with the liquid LQ. In addition, it is also possible to use a liquid LQ that has transmittivity with respect to the exposure light EL, has as high a refractive index as possible, and is stable with respect to the photosensitive material that is coated onto the projection optical system PL and the upper surface of the substrate P (base material 1) (for example, cedar oil). In this case as well, surface treatment is performed according to the polarity of the liquid LQ used.

Note that, applicable as the substrate P of the aforementioned respective embodiments are not only a semiconductor wafer for the manufacture of semiconductor devices but glass substrates for display devices, ceramic wafers for thin film magnetic heads, or mask or reticle base plates, etc. (synthetic quartz, silicon wafer) used in exposure apparatuses.

Applicable as the exposure apparatus EX are, in addition to step and scan system scanning exposure apparatuses (scanning steppers) that synchronously move the mask M and the substrate P to scan expose the pattern of a mask M, step and repeat system projection exposure apparatuses (steppers) that full-field expose the pattern on the mask M in a status in which the mask M and the substrate P have been made stationary and sequentially step move the substrate P. In the embodiment discussed above, a light transmitting type mask (reticle) in which a prescribed light shielding pattern (or phase pattern / light reduction pattern) has been formed on a light transmissive substrate is used, but, instead of this reticle, an electronic mask that forms a transmission pattern or reflection pattern or a light emission pattern based on electronic data of the pattern to be exposed may be used as disclosed, for example, in U.S. Patent No. 6,778,257.

In addition, application to an exposure apparatus of a system that full-field exposes a reduced image of a first pattern onto a substrate P using as the exposure apparatus EX a projection optical system (for example, a refracting projection optical system that does not include a reflecting element and whose reduction ratio is 1/8) in a status in which both the first pattern and the substrate P have been made nearly stationary is also possible. In this case, it is also applicable to a stitch system full-field exposure apparatus that subsequently full-field exposes a reduced image of the second pattern onto a substrate P so that it is partially superposed with the first pattern using that projection optical system in a status in which the second pattern and the substrate P have been made nearly stationary. In addition, for the stitch system exposure apparatus, application to a step and stitch system exposure apparatus that partially superposes at least two patterns on the substrate P and sequentially moves the substrate P is also possible. In addition, it is also possible to apply the present invention to an exposure apparatus (lithography system) that exposes a line and space pattern onto a substrate P by forming interference fringes on the substrate P as disclosed in the PCT International Publication No. WO 2001/035168, and it is also possible to omit a projection optical system for projecting a pattern image onto a substrate P.

In addition, the present invention is also applicable to a twin-stage type exposure apparatus disclosed in, for example, Japanese Unexamined Patent Application Publication No. H10-163099, Japanese Unexamined Patent Application Publication No. H10-214783 and Published Japanese Translation No. 2000-505958 of the PCT International Application.

In addition, in the embodiments described above, an exposure apparatus that locally fills the space between the projection optical system PL and the substrate P with liquid is employed, but the present invention may also be applied to a liquid immersion exposure apparatus that covers the entire surface of the substrate to be exposed with the liquid, such as those disclosed in Japanese Unexamined Patent Application Publication No. H6-124873 and Japanese Unexamined Patent Application Publication No. H10-303114.

The types of exposure apparatuses EX are not limited to exposure apparatuses for semiconductor device fabrication that expose a semiconductor device pattern on a substrate P but are also widely applicable to exposure apparatuses for the manufacture of liquid crystal display elements and for the manufacture of displays, and exposure apparatuses for the manufacture of thin film magnetic heads, image pickup elements (CCDs), or reticles or masks.

In the case where a linear motor is used in the substrate stage apparatus PST or the mask stage apparatus MST (see USP 5,623,853 or USP 5,528,118), an air floating type that uses air bearings or a magnetic levitation type that uses Lorentz force or reactance force may be used. In addition, the respective stages PST, MST may be the types that move along a guide or may be the guideless type in which a guide is not provided.

For the drive mechanisms of the respective stage apparatuses PST, MST, a planar motor that places in opposition a magnet unit that two-dimensionally arranges magnets and an armature unit that arranges coils two-dimensionally and drives the respective stages PST, MST by electromagnetic force may be used. In such a case, either the magnet unit or the armature unit is connected to the stage apparatuses PST, MST, and the other from among the magnet unit and the armature unit may be provided on the moving surface side of the stage apparatus PST, MST.

The reaction force generated by the movement of the substrate stage apparatus PST may be caused to mechanically escape to the floor (ground) using a frame member so that it is not transmitted to the projection optical system PL, as described in Japanese Unexamined Patent Application Publication No. H8-166475 (USP 5,528,118).

The reaction force generated by the movement of the mask stage apparatus MST may be caused to mechanically escape to the floor (ground) using a frame member so that it is not transmitted to the projection optical system PL, as described in Japanese Unexamined Patent Application Publication No. H8-330224 (USP 5,874,820).

As discussed above, the exposure apparatus EX of the present embodiment is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly of the various subsystems to the exposure apparatus has ended, overall adjustment is performed, and the various precisions are ensured for the exposure apparatus as a whole. Note that it is preferable that the manufacture of the exposure apparatus be performed in a clean room in which the temperature, the degree of cleanliness, etc. are controlled.

As shown in FIG. 11, microdevices such as semiconductor devices are manufactured by going through a step 201 that performs microdevice function and performance design, a step 202 that creates the mask (reticle) based on this design step, a step 203 that manufactures the substrate that is the device base material, a substrate processing step 204 that exposes the pattern on the mask onto a substrate by means of an exposure apparatus EX of the embodiments discussed above, a device assembly step (including the dicing process, bonding process and packaging process) 205, an inspection step 206, etc.

**Claims**

1.  A substrate for exposure that is to be exposed by exposure light being radiated through a liquid, wherein the dimensional tolerance of the outer diameter is $\pm 0.02$ mm or less.

2.  A substrate for exposure according to Claim 1 that includes a semiconductor wafer.

3.  An exposure method that radiates the exposure light to expose the substrate for exposure in a status in which the substrate for exposure defined in Claim 1 or Claim 2 is held by a holder.

4.  An exposure method according to Claim 3; wherein
    the holder holds a plate member in which an opening part is formed,
    the substrate for exposure is arranged so that an inner side surface of the opening part and an outer side surface of the substrate for exposure oppose each other, and
    the dimensional tolerance of the outer diameter of the substrate for exposure is determined while taking into account the dimensional tolerance of the inner diameter of the inner side surface.

5.  An exposure method according to Claim 4; wherein the surface of the substrate for exposure and the surface of the plate member are substantially flush.

6.  An exposure method according to Claim 4 or Claim 5; wherein
    a liquid repellent material film is formed on the inner side surface of the plate member, and
    the dimensional tolerance of the outer diameter of the substrate for exposure is determined while taking into account the tolerance of the thickness of the film.

7.  An exposure method according to any one of Claims 4 to 6; wherein
    the plate member is removably and attachably held by the holder, and
    the dimensional tolerance of the outer diameter of the substrate for exposure is determined while taking into account the positioning accuracy of the plate member with respect to an ideal position on the holder.

8.  An exposure method according to any one of Claims 4 to 7; wherein
    the gap between the outer side surface of the substrate for exposure and the inner side surface of the plate member is 0.3 mm or less.

9.  An exposure method according to any one of Claims 3 to 8; wherein
    the substrate for exposure is loaded onto the holder by a loader apparatus, and
    the dimensional tolerance of the outer diameter of the substrate for exposure is determined while taking into account the position accuracy of loading of the substrate for exposure onto the holder by the loader apparatus.

10. An exposure method according to any one of Claims 3 to 9; wherein
    a stage apparatus that moves the holder is provided, and
    the dimensional tolerance of the outer diameter of the substrate for exposure is determined while taking into account the positioning accuracy when positioning has been performed with respect to an ideal position after initialization of the stage apparatus has been performed.

11. An exposure method according to Claim 3; wherein the dimensional tolerance of the outer diameter of the substrate for exposure is determined so that the gap between the outer side surface of the substrate for exposure held by the holder and the inner side surface of a member arranged in the vicinity of the substrate for exposure held by the holder becomes 0.3 mm or less.

12. A device manufacturing method that uses an exposure method defined in any one of Claims 3 to 11.

# FIG. 1A

# FIG. 1B

FIG. 2

$Dp\ (=D_1+D_2)$

1A     Pa

2 } P

1C
Pc
1

$L_2/2$     1B     $L_1$     Pb     $L_2/2$

Lp

FIG. 3

$Dp\ (=D_1+D_3)$

1A     Pa

3
2 } P
1

1C
Pc

$L_3/2$     1B     $L_1$     Pb     $L_3/2$

Lp

FIG. 4

$Dp\ (=D_1+D_2+D_3)$

1A     Pa

3
2 } P
1

1C
Pc

$L_3/2$  $L_2/2$     1B     $L_1$     Pb     $L_2/2$  $L_3/2$

Lp

# FIG. 5

EP 1 804 279 A1

# FIG. 6

EP 1 804 279 A1

# FIG. 7

FIG. 8

# FIG. 9

EP 1 804 279 A1

FIG. 10

## FIG. 11

DESIGN
(FUNCTIONS, PERFORMANCE AND PATTERN) — 201

SUBSTRATE MANUFACTURE — 203

MASK CREATION — 202

SUBSTRATE PROCESSING — 204

DEVICE ASSEMBLY — 205

INSPECTION — 206

(SHIPPING)

## FIG. 12

## INTERNATIONAL SEARCH REPORT

| | International application No. |
|---|---|
| | PCT/JP2005/017180 |

A. CLASSIFICATION OF SUBJECT MATTER
*H01L21/027*(2006.01), *G03F7/20*(2006.01), *H01L21/02*(2006.01)

According to International Patent Classification (IPC) or to both national classification and IPC

B. FIELDS SEARCHED

Minimum documentation searched (classification system followed by classification symbols)
*H01L21/027*(2006.01), *G03F7/20*(2006.01), *H01L21/02*(2006.01), *B24B9/00*
(2006.01), *H01L21/304*(2006.01)

Documentation searched other than minimum documentation to the extent that such documents are included in the fields searched
|  |  |  |  |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2004-207710 A  (Nikon Corp.),<br>22 July, 2004 (22.07.04),<br>Par. Nos. [0033], [0034]; Fig. 4<br>& WO 2004/053954 A1 | 1-12 |
| X | EP 1429188 A2  (ASML NETHERLANDS B.V.),<br>16 June, 2004 (16.06.04),<br>Par. Nos. [0043] to [0060]; Figs. 5 to 7<br>& JP 2004-289127 A | 1-12 |
| X | JP 10-303114 A  (Nikon Corp.),<br>13 November, 1998 (13.11.98),<br>Par. No. [0015]; Fig. 1<br>(Family: none) | 1-12 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 December, 2005 (19.12.05) | 27 December, 2005 (27.12.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
|---|
| PCT/JP2005/017180 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-001655 A (Nippei Toyama Corp.),<br>08 January, 2002 (08.01.02),<br>Page 1<br>(Family: none) | 1-12 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004271636 A
- WO 9949504 A
- JP H837149 A
- JP H6188169 A
- JP H653120 A
- JP H4277612 A
- JP 2001345245 A
- WO 2004019128 A
- US 6778257 B
- WO 2001035168 A

- JP H10163099 A
- JP H10214783 A
- JP 2000505958 W
- JP H6124873 A
- JP H10303114 A
- US 5623853 A
- US 5528118 A
- JP H8166475 B
- JP H8330224 A
- US 5874820 A